# FASCICULE DE BREVET EUROPEEN

(11) **EP 0 762 819 B1**
(45) Date de publication et mention de la délivrance du brevet: **31.03.1999**
(21) Numéro de dépôt: 96401809.7
(22) Date de dépôt: 22.08.1996
(51) Int. Cl.: H05K 7/18

(54) **Ossature d'armoire, notamment pour appareillages électriques**
Schrankrahmen, insbesondere für elektrische Apparaturen
Cabinet frame, particularly for electrical apparatus

(30) Priorité: 24.08.1995 FR 9510054
(43) Date de publication de la demande: 12.03.1997
(73) Titulaire: LEGRAND, F-87045 Limoges Cédex (FR); LEGRAND SNC, F-87045 Limoges (FR)
(72) Inventeur: Dufosse, David, 76150 Maromme (FR)
(74) Mandataire: CABINET BONNET-THIRION

(56) Documents cités:
- EP-A- 0 533 557
- DE-U- 9 017 234
- DE-U- 9 405 618
- US-A- 3 725 746
- US-A- 5 372 262

## Description

La présente invention concerne d'une manière générale les armoires du type de celles mises en oeuvre pour le logement, par exemple, d'appareillages électriques.

Elle vise plus particulièrement celles de ces armoires qui sont dites assemblables, c'est-à-dire celles dont le montage final peut si désiré être effectué in situ et/ou qui sont susceptibles d'une réalisation modulaire.

Plus particulièrement, encore, la présente invention vise celles de ces armoires dont l'ossature comporte, entre deux panneaux d'extrémité, l'un formant plancher, l'autre formant toit, une pluralité de montants parallèles, parmi lesquels il est possible de distinguer, d'une part, des montants de structure, qui s'étendent de l'un à l'autre des panneaux d'extrémité à leurs angles, et qui définissent conjointement dans l'armoire au moins un compartiment, dit ci-après par simple commodité compartiment principal, en étant chacun respectivement disposés suivant les arêtes verticales de ce compartiment principal, et, d'autre part, des montants de support, qui interviennent dans le compartiment principal, entre les faces avant et arrière de celui-ci, et qui sont destinés à permettre la constitution d'un châssis, parallèlement à ces faces avant et arrière, pour le support d'un quelconque équipement.

Lorsque cet équipement est formé d'appareillages électriques ou comporte de tels appareillages électriques, il est nécessaire d'assurer leur câblage.

Il est donc nécessaire d'avoir accès à ces appareillages électriques, le plus souvent à l'arrière de ceux-ci, et de disposer d'une place suffisante pour le passage des câbles correspondants.

Le plus souvent, à ce jour, les montants de structure sont pris en sandwich entre les panneaux d'extrémité entre lesquels ils s'étendent, et ils sont ainsi indissociables de ceux-ci.

Ils constituent dès lors inévitablement une gêne lors du câblage des appareillages électriques.

La présente invention a d'une manière générale pour objet une disposition permettant d'éviter cet inconvénient et conduisant en outre à d'autres avantages.

De manière plus précise, elle a pour objet une ossature d'armoire du genre comportant, entre deux panneaux d'extrémité, l'un formant plancher, l'autre formant toit, une pluralité de montants parallèles, dont, d'une part, des montants de structure, qui s'étendent de l'un à l'autre des panneaux d'extrémité à leurs angles, et qui définissent conjointement au moins un compartiment, dit compartiment principal, en étant disposés chacun respectivement suivant les arêtes verticales de ce compartiment principal, et, d'autre part, des montants de support, qui interviennent dans le compartiment principal, entre les faces avant et arrière de celui-ci, et qui sont destinés à permettre la constitution d'un châssis pour le support d'un quelconque équipement à loger dans ce compartiment principal, les deux panneaux d'extrémité présentant dans leurs angles des embouts entre lesquels s'étendent les montants de structure, cette ossature étant caractérisée en ce que, ceux, au moins, de ces montants de structure qui interviennent sur la face avant du compartiment principal sont chacun individuellement rapportés de manière amovible sur les embouts entre lesquels ils s'étendent, et les montants de support sont déportés vers l'intérieur du compartiment principal par rapport aux faces latérales de celui-ci.

Ainsi, lors du câblage d'éventuels appareillages électriques, il est avantageusement possible de procéder à la dépose, et, plus précisément, à la dépose par l'avant, de ces montants de structure, ce qui facilite avantageusement l'accès à ces appareillages électriques.

Conjointement, le déport vers l'intérieur des montants de support ménage avantageusement entre ceux-ci et les faces latérales du compartiment principal un espace libre facilitant le passage des câbles nécessaires, soit que ces câbles soient mis en oeuvre isolément, soit qu'ils soient disposés à l'intérieur de goulottes propres à discipliner leur parcours et à en assurer la protection.

Certes, il a déjà été décrit, dans le brevet français déposé sous le No 91 11485 et publié sous le No 2 681 405, une ossature d'armoire dont certains des montants, étant les montants intermédiaires entre deux montants d'angle, sont amovibles.

Il n'en est pas de même dans l'ossature d'armoire suivant l'invention, dans laquelle, au contraire, les montants de structure d'angle sont amovibles.

Egalement, il a déjà été proposé une ossature d'armoire comportant, entre les deux panneaux d'extrémité, des montants de structure qui sont tous déportés vers l'intérieur.

Si, enfin, il a été proposé, dans le brevet américain No 3 725 746, une ossature d'armoire comportant des montants de structure à l'avant et à l'arrière d'un compartiment, ces montants de structure d'angle ne sauraient être amovibles au sens de la présente demande de brevet, parce que leur dépose ne peut pas se faire sans que la tenue de l'ossature soit compromise.

En effet, d'une part, ces montants de structure sont emmanchés sur des embouts appartenant aux panneaux d'extrémité entre lesquels ils s'étendent, et, d'autre part, ils ont transversalement une section en C qui se referme partiellement par des retours à l'arrière de ces embouts.

Pour déposer de tels montants de structure, il faut donc procéder à un démontage général de l'ensemble.

En outre, dans ce brevet américain No 3 725 746, les montants de support portant la plaque qui tient lieu de châssis ne sont pas déportés vers l'intérieur du compartiment par rapport aux montants de structure précédents.

L'ossature d'armoire décrite dans ce brevet américain No 3 725 746 relève donc d'une constitution générale très différente de celle faisant l'objet de la présente invention.

Les caractéristiques et avantages de l'invention ressortiront d'ailleurs de la description qui va suivre, à titre d'exemple, en référence aux dessins schématiques annexés sur lesquels :
la figure 1 est une vue en perspective, en partie éclatée, et avec des arrachements locaux et des pièces enlevées, d'une ossature d'armoire suivant l'invention ;
la figure 2 en est, à échelle inférieure, une vue en plan-coupe, suivant la ligne II-II de la figure 1 ;
la figure 3 est une vue en perspective d'une des noix d'angle que comporte cette ossature d'armoire, avec, de manière éclatée, une partie d'un montant de structure à engager sur l'embout qu'elle forme et les organes de fixation associés à celui-ci ;
la figure 4 est une vue en coupe de cette noix d'angle, suivant son plan de symétrie matérialisé par la ligne IV-IV sur la figure 3, avec, de manière éclatée, l'un des constituants d'un des organes de fixation associés à un montant de structure ;
la figure 5 est une vue en perspective qui, reprenant, à échelle supérieure, le détail de la figure 1 repéré par un encart V sur cette figure 1, est relative à l'une des consoles entre lesquelles s'étendent les montants de support que comporte l'ossature d'armoire suivant l'invention, avec, de manière éclatée, une vis de fixation ;
la figure 6 est une vue partielle en coupe transversale de cette ossature d'armoire, suivant la ligne VI-VI de la figure 5 ;
les figures 7A et 7B sont des vues partielles en perspective illustrant l'assemblage, à l'ossature d'armoire suivant l'invention, d'une ossature annexe ;
la figure 8 est, suivant l'orientation des figures 7A et 7B, une vue en perspective d'une patte de juxtaposition mise en oeuvre pour un tel assemblage ;
les figures 9A et 9B sont des vues partielles en perspective illustrant l'assemblage, l'une à l'autre, de deux ossatures d'armoire suivant l'invention.

Tel qu'illustré sur ces figures, et de manière connue en soi, l'ossature d'armoire 10 suivant l'invention comporte, globalement, entre deux panneaux d'extrémité 11A, 11B, l'un formant plancher, l'autre formant toit, une pluralité de montants parallèles, dont, d'une part, des montants de structure 12, qui s'étendent de l'un à l'autre de ces panneaux d'extrémité 11A, 11B, et qui définissent conjointement au moins un compartiment 13, dit compartiment principal, en étant chacun respectivement disposés suivant les arêtes verticales de ce compartiment principal 13, et, d'autre part, des montants de support 14, qui interviennent dans le compartiment principal 13, entre les faces avant 15 et arrière 16 de celui-ci, et qui, suivant des dispositions qui, ne relevant pas de la présente invention, ne seront pas décrites ici, sont destinés à permettre la constitution d'un châssis 18, pour le support d'un quelconque équipement, non représenté, à loger dans ce compartiment principal 13.

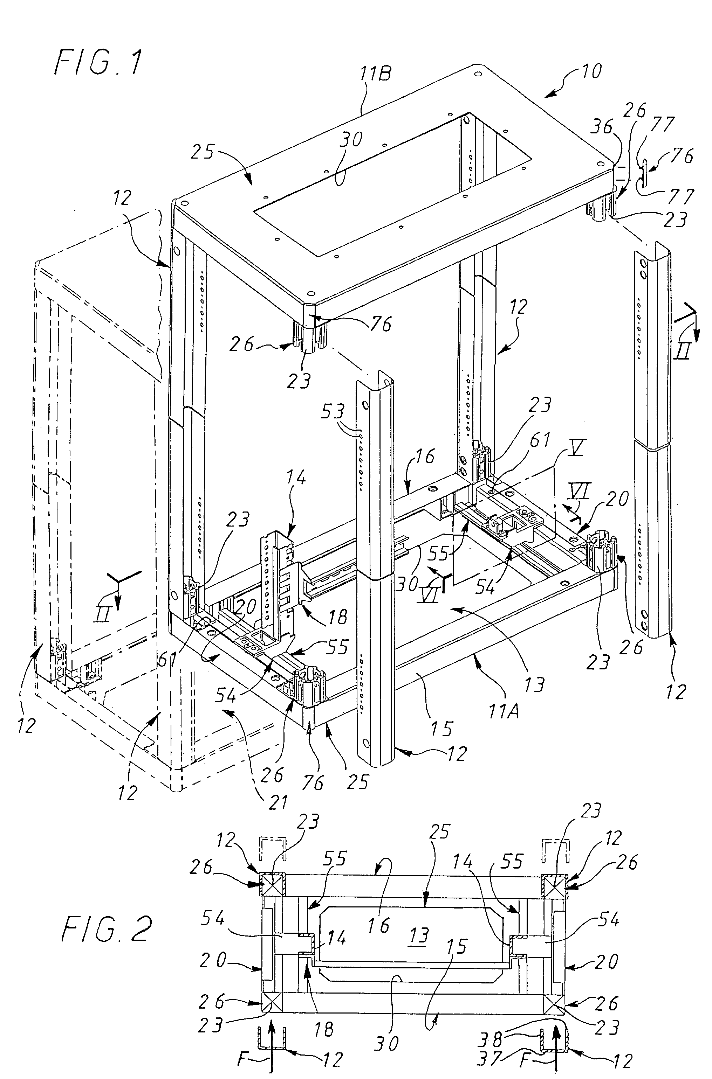

Dans la forme de réalisation représentée en traits continus sur la figure 1, un seul compartiment est prévu, en l'espèce le compartiment principal 13, en sorte que l'ossature d'armoire 10 ne comporte que quatre montants de structure 12 et qu'il s'agit pour tous de montants d'angle, c'est-à-dire de montants intervenant à la jonction entre l'une des faces avant 15 ou arrière 16 de ce compartiment principal 13 et l'une ou l'autre de ses faces latérales 20.

Mais, tel que schématisé en traits interrompus sur cette figure 1, il peut être prévu, de manière intégrée, dans l'alignement du compartiment principal 13, à compter d'une des faces latérales 20 de celui-ci, un compartiment annexe 21, par exemple pour la constitution d'une gaine à câbles, en sorte que l'ossature d'armoire 10 comporte alors six montants de structure 12 dont quatre montants d'angle, comme précédemment, et, à la jonction entre le compartiment principal 13 et le compartiment annexe 21, deux montants intermédiaires.

En toute hypothèse, les panneaux d'extrémité 11A, 11B ont, en plan, un contour globalement quadrangulaire, et, en pratique, rectangulaire.

Suivant l'invention, les panneaux d'extrémité 11A, 11B présentant, au moins dans leurs angles, suivant des dispositions qui seront décrites plus en détail ultérieurement, des embouts 23 entre lesquels s'étendent les montants de structure 12, ceux, au moins, de ces montants de structure 12 qui interviennent sur la face avant 15 du compartiment principal 13 sont chacun individuellement rapportés, de manière amovible, suivant des dispositions qui seront également décrites plus en détail ultérieurement, sur les embouts 23 entre lesquels ils s'étendent, et, conjointement, les montants de support 14 sont décalés vers l'intérieur du compartiment principal 13 par rapport aux faces latérales 20 de celui-ci.

Dans la forme de réalisation représentée, les panneaux d'extrémité 11A, 11B ont l'un et l'autre des structures de même type.

Ils sont en pratique formés chacun, d'une part, d'un platelage 25, et, d'autre part, de quatre noix d'angle 26, qui sont toutes identiques entre elles, et qui, disposées chacune respectivement aux angles du platelage 25, comportent, chacune, en trièdre, d'une part, deux bras 27, par lesquels elles sont solidarisées au platelage 25, tel que décrit ci-après, et, d'autre part, l'embout 23 sur lequel est engagé le montant de structure 12 correspondant.

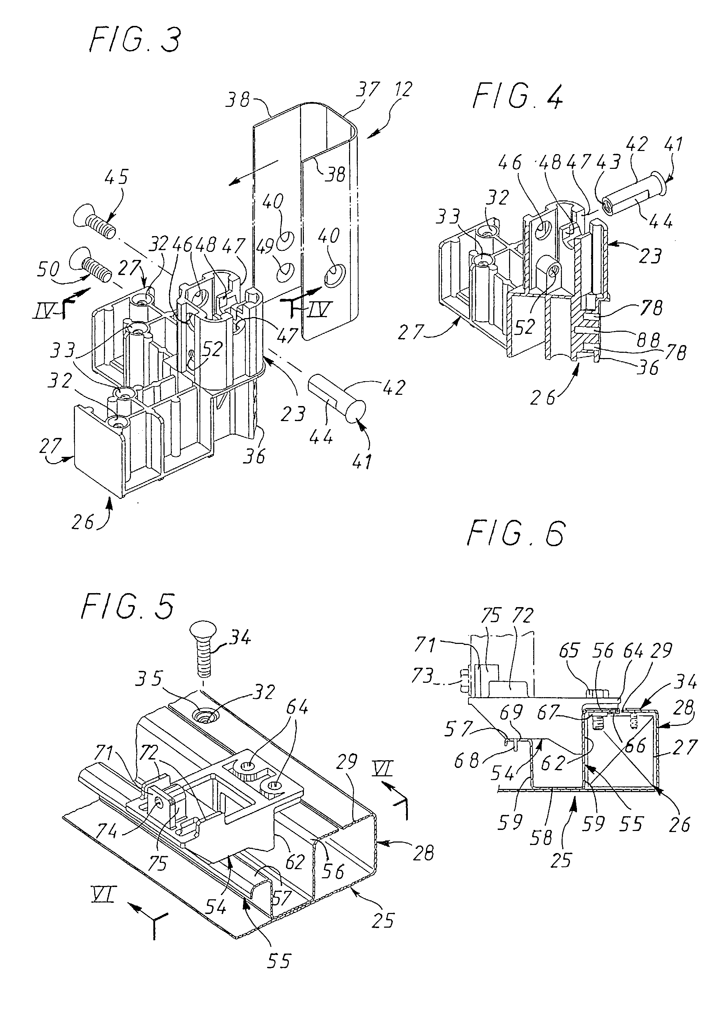

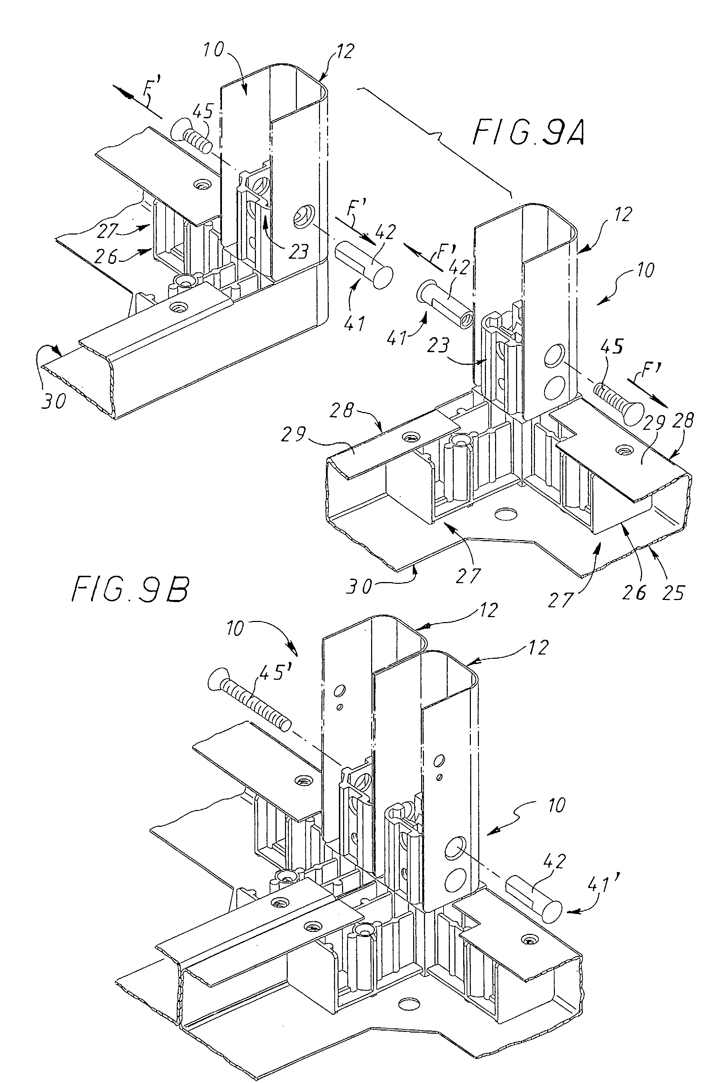

Dans la forme de réalisation représentée, le platelage 25 comporte, le long de chacun de ses bords, et ainsi qu'il est mieux visible pour l'un d'eux sur les figures 5 et 6, un repli en U 28, dont le retour terminal 29 est dirigé vers l'intérieur du compartiment principal 13, et ainsi qu'il est mieux visible pour l'une d'elles sur les figures 9A et 9B, chacune des noix d'angle 26 est engagée par chacun de ses bras 27 dans le repli en U 28 correspondant de ce platelage 25.

Dans la forme de réalisation représentée, le platelage 25 est en outre largement ajouré par un évidement 30 dans sa zone centrale.

Les bras 27 d'une noix d'angle 26 ont une section transversale qui est globalement quadrangulaire, et plus précisément carrée, au profil des replis en U 28 du platelage 25.

Parallèlement à l'embout 23, ils présentent, chacun, à compter de leur face supérieure, deux puits taraudés 32, 33, l'un disposé au voisinage de leur bord externe, l'autre disposé au voisinage de leur bord interne, figures 3 et 4.

Par coopération avec une vis 34, visible sur les figures 5 et 6, le puits taraudé 32 sert à la solidarisation au platelage 25 concerné, le retour terminal 29 des replis en U 28 de celui-ci présentant en correspondance un perçage 35.

Comme les bras 27, l'embout 23 a une section transversale qui est globalement quadrangulaire, et plus précisément carrée, avec, cependant, des angles qui sont, soit adoucis par un arrondi, ce qui est le cas des trois angles externes, soit abattus par un chanfrein, ce qui est le cas de l'angle interne.

Pour des raisons qui apparaîtront ci-après, une noix d'angle 26 présente, extérieurement, à la jonction de ses bras 27, en dessous de son embout 23, un méplat à 45° 36.

Globalement, le plan bissecteur des bras 27 d'une noix d'angle 26 passant par son embout 23 est un plan de symétrie pour l'ensemble.

Il s'agit du plan de coupe de la figure 4.

En pratique, et tel que représenté, une noix d'angle 26 est une pièce moulée, qui, pour son allégement, présente de nombreux évidements.

L'implantation et la configuration de ceux-ci relevant de l'homme de l'art, il n'est pas nécessaire de les détailler ici.

Dans la forme de réalisation représentée, les montants de structure 12 sont des profilés à section transversale en U, à partie médiane 37 et ailes latérales 38, et leur concavité est orientée vers l'intérieur du compartiment principal 13, suivant la face latérale 20 correspondante de celui-ci.

Autrement dit, et tel que schématisé par des flèches F sur la figure 2, les montants de structure 12 intervenant sur la face avant 15 du compartiment principal 13 s'emboîtent de l'avant sur les embouts 23 correspondants des panneaux d'extrémité 11A, 11B, perpendiculairement à cette face avant 15.

A chacune des extrémités d'un montant de structure 12, les ailes latérales 38 de ce montant de structure 12 présentent, en regard l'une de l'autre, au moins un perçage 40, pour l'intervention d'un premier organe de fixation, en l'espèce un tirant 41, qui, traversant de part en part l'embout 23 correspondant, assure le pincement de ce montant de structure 12 sur cet embout 23, figure 3.

En pratique, le tirant 41 est formé, d'une part, d'une douille entretoise 42, dont l'alésage interne 43 est taraudé, figure 4, et qui présente extérieurement au moins un méplat 44 pour son blocage en rotation sur l'embout 23, et, en pratique, en positions diamétralement opposées l'un par rapport à l'autre, deux méplats 44, et, d'autre part, d'une vis 45 en prise avec cette douille entretoise 42.

Pour le passage d'un tel tirant 41, l'embout 23 d'une noix d'angle 26 présente, en vis-à-vis, pour chacun des bras 27, d'une part, du côté d'un tel bras 27, un perçage 46, à la faveur duquel intervient la vis 45, et, d'autre part, du côté opposé au précédent, un évidement 47, à la faveur duquel intervient la douille entretoise 42.

En pratique, pour des raisons de commodité de moulage, et, notamment, pour faciliter la formation de méplats 48 propres à coopérer avec les méplats 44 de la douille entretoise 42, l'évidement 47 est ouvert vers le haut, et a donc globalement une forme de berceau ou de gouttière.

Préférentiellement, et tel que représenté, à chacune des extrémités d'un montant de structure 12, l'une au moins des ailes latérales 38 de ce montant de structure 12 présente au moins un perçage 49 supplémentaire, pour l'intervention d'un deuxième organe de fixation, en l'espèce une vis 50, figure 3.

En pratique, cette vis 50 est directement en prise avec l'embout 23.

En pratique, également, seule l'une des ailes latérales 38 d'un montant de structure 12 présente ainsi un tel perçage 49 supplémentaire.

En correspondance, l'embout 23 d'une noix d'angle 26 présente, du côté de chacun de ses bras 27, et parallèlement à un tel bras 27, un perçage taraudé 52, figures 3 et 4.

Dans la forme de réalisation représentée, les montants de structure 12 sont tous identiques entre eux.

Il en résulte que, comme ceux intervenant sur la face avant 15 du compartiment principal 13, les montants de structure 12 intervenant sur la face arrière 16 de ce compartiment principal 13 sont également chacun individuellement rapportés de manière amovible sur les embouts 23 entre lesquels ils s'étendent.

Dans la forme de réalisation représentée, et pour des raisons qui n'ont pas à être explicitées ici, les montants de structure 12 présentent, de place en place, le long de leurs ailes latérales 38, des perçages 53, figure 1.

En pratique, et par construction, les montants de structure 12 s'étendent sur toute la hauteur de l'ossature d'armoire 10.

Il n'en est pas nécessairement de même des montants de support 14.

Dans la forme de réalisation représentée, deux montants de support 14 sont prévus.

Ils s'étendent dans un plan qui est parallèle aux faces avant 15 et arrière 16 du compartiment principal 13, à distance de l'une et de l'autre de celles-ci.

Dans la forme de réalisation représentée, chacun de ces montants de support 14 s'étend entre deux consoles 54 dont chacune est solidaire d'un profilé 55 parallèle à la face latérale 20 correspondante du compartiment principal 13.

Ainsi qu'il est mieux visible sur les figures 5 et 6, ce profilé 55 présente, à des niveaux différents, deux épaulements 56, 57, l'un, supérieur, suivant lequel la console 54 lui est solidarisée, l'autre, inférieur, contre lequel cette console 54 est en simple appui.

En pratique, le profilé 55 a une section transversale en U, avec une partie médiane 58, par laquelle il porte contre le platelage 25 correspondant, et des ailes latérales 59, de hauteurs inégales.

Les épaulements 56, 57 sont formés par des retours de ces ailes latérales 59 dirigés en sens opposés l'un par rapport à l'autre.

En pratique, celui de ces retours qui forme l'épaulement 56 supérieur est à niveau avec le retour terminal 29 des replis en U 28 du platelage 25.

En pratique, également, le profilé 55 s'étend de l'une à l'autre de deux noix d'angle 26, au contact du platelage 25 du panneau d'extrémité 11A, 11B concerné, et, par des vis non représentées, il est solidarisé aux bras 27 correspondants de ces noix d'angle 26, à la faveur du puits taraudé 33 de ces bras 27, celui de ses retours qui forme son épaulement 56 supérieur présentant à cet effet un perçage 61 à chacune de ses extrémités, figure 1.

Par un dégagement en équerre 62, figures 5 et 6, la console 54 est emboîtée sur l'épaulement 56 supérieur du profilé 55, et elle forme deux oreilles 64 pour le passage de vis 65 propres à sa solidarisation au retour du profilé 55 formant cet épaulement 56 supérieur.

Par exemple, et tel que représenté à la figure 6, il est engagé, à cet effet, sur ce retour du profilé 55, des agrafes 66 porteuses chacune d'un écrou 67, ce retour présentant par ailleurs en correspondance des perçages propres au passage des vis 65.

Par une languette 68 en saillie sur sa surface inférieure, la console 54 est en prise avec un évidement 69 prévu en correspondance à cet effet sur le retour du profilé 55 formant l'épaulement 57 inférieur de celui-ci, ce qui concourt à son blocage en position sur ce profilé 55.

Sur sa surface supérieure, la console 54 présente, en saillie, pour l'emboîtement d'un montant de support 14, d'une part, le long de son bord avant, une languette 71, et, d'autre part, le long de chacun de ses bords latéraux, une languette 72.

Pour la solidarisation, à l'aide d'une vis 73, du montant de support 14, la languette 71 présente un perçage taraudé 74, qui se prolonge sur sa face arrière à la faveur d'un bossage 75.

Dans la forme de réalisation représentée, le montant de support 14 recouvre de l'avant la languette 71 et s'étend à l'arrière des languettes 72.

La configuration propre de ce montant de support 14 ne relevant pas de la présente invention, elle ne sera pas détaillée ici.

Il suffira d'indiquer que, dans la forme de réalisation représentée, il a lui aussi globalement une section transversale en U.

En pratique, pour qu'un accès au méplat à 45° 36 des noix d'angle 26 soit possible, les replis en U 28 du platelage 25 des panneaux d'extrémité 11A, 11B s'arrêtent à distance les uns des autres.

Pour camoufler, dès lors, un tel méplat à 45° 36, il est associé, à chaque noix d'angle 26, un cache 76.

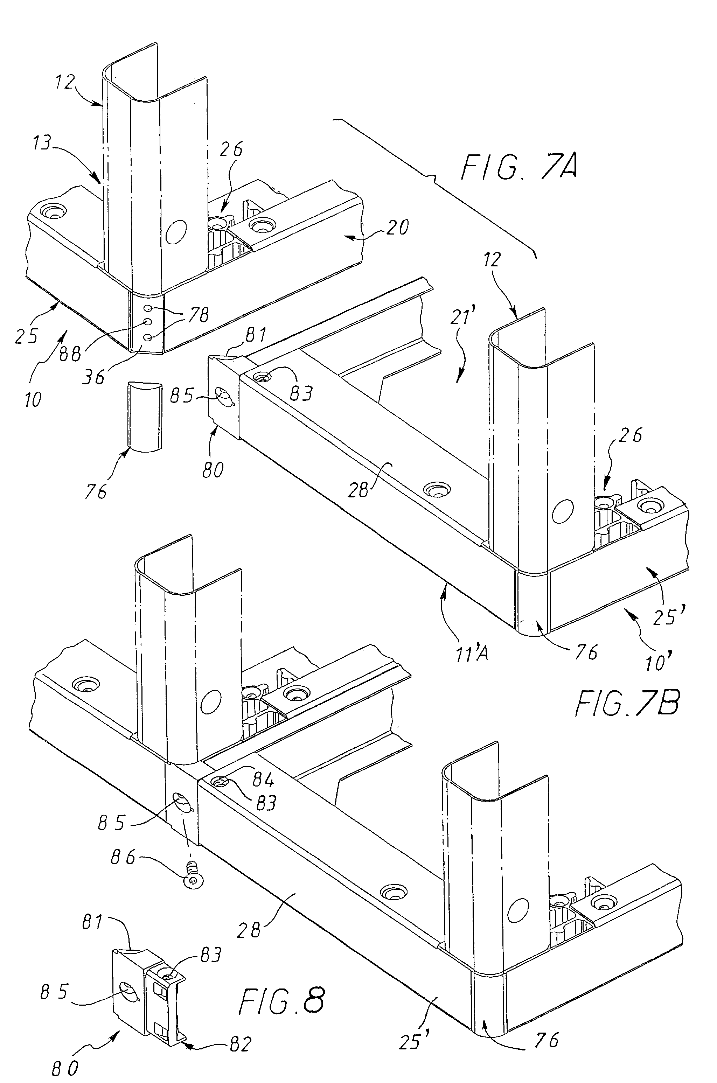

Ainsi qu'il est visible pour l'un d'eux sur les figures 1 et 7A, un tel cache 76 est amovible.

Il présente, en saillie, des ergots 77, figure 1, par lesquels il peut être engagé, en force, dans des perçages 78 prévus en correspondance sur le méplat à 45° 36 à habiller, figures 4 et 7A.

Bien entendu, l'ossature d'armoire 10 suivant l'invention est conjointement adaptée à recevoir si désiré d'autres pièces d'habillage, telles que porte avant, panneaux latéraux et panneau arrière, non représentées.

Les dispositions correspondantes ne relevant pas de la présente invention, elles ne seront pas décrites ici.

Après élimination des caches 76 concernés, et tel que représenté sur les figures 7A et 7B, le méplat à 45° 36 des noix d'angle 26 peut être mis à profit, si désiré, pour l'assemblage, à une ossature d'armoire 10, d'une ossature annexe 10', de constitution sensiblement analogue, à panneaux d'extrémité 11'A (ou 11'B, non représenté), montants de structure 12 et noix d'angle 26, pour la formation d'un compartiment annexe 21' accolé au compartiment principal 13 le long d'une des faces latérales 20 de celui-ci.

Il est prévu, à cet effet, de manière distincte, une patte de juxtaposition 80, qui, destinée à équiper, dans chacun de leurs angles concernés, à la place d'une noix d'angle 26, l'un et l'autre des panneaux d'extrémité 11'A (11'B) de cette ossature annexe 10', comporte, elle-même, de manière complémentaire, un méplat à 45° 81.

Cette patte de juxtaposition 80, représentée isolément à la figure 8, présente un embout 82, par lequel elle peut être emboîtée dans le repli en U 28 du platelage 25' du panneau d'extrémité 11'A (ou 11'B) concerné de l'ossature annexe 10', et, pour sa solidarisation à cette ossature annexe 10', cet embout 82 présente, transversalement, au moins un puits taraudé 83, pour coopération avec une vis, non représentée, le retour terminal 29 du repli en U 28 du platelage 25' comportant en correspondance un perçage 84.

En pratique, pour que la patte de juxtaposition 80 puisse indifféremment convenir à l'un et l'autre des angles concernés, son embout 82 présente, dos à dos, respectivement sur sa face inférieure et sur sa face supérieure, deux puits taraudés 83, dont un seul est visible sur les figures.

Corollairement, pour sa solidarisation à la noix d'angle 26 correspondante de l'ossature d'armoire 10, la patte de juxtaposition 80 présente, en oblique perpendiculairement à son méplat à 45° 81, un perçage 85, pour coopération avec une vis 86, le méplat à 45° 36 de cette noix d'angle 26 présentant, lui-même, en correspondance, entre ses perçages 78, un perçage taraudé 88, figures 4 et 7A.

Tel que schématisé sur les figures 9A et 9B, deux ossatures d'armoire 10 suivant l'invention peuvent également être assemblées l'une à l'autre.

Il suffit de retirer les tirants 41 des montants de structure 12 par lesquels elles doivent être accolées, et, donc, de procéder à la dépose des douilles entretoises 42 et des vis 45 constitutives de ces tirants 41, tel que schématisé par des flèches F' sur la figure 9A, puis de substituer à ces tirants 41, un tirant unique 41', formé, d'une part, d'une douille entretoise 42 identique aux précédentes, et, d'autre part, d'une vis 45' de longueur suffisante pour traverser conjointement les deux montants de structure 12 et ainsi atteindre la douille entretoise 42.

Dans toutes les configurations, chacun des montants de structure 12 peut individuellement être déposé, voire même conjointement avec un autre montant de structure, sans que la tenue d'ensemble de l'ossature 10 ou 10' correspondante soit compromise.

Bien entendu, la présente invention ne se limite pas à la forme de réalisation décrite et représentée, mais englobe toute variante d'exécution qui est conforme à la revendication 1.

## Revendications

1. Ossature d'armoire, du genre comportant, entre deux panneaux d'extrémité (11A, 11B), l'un formant plancher, l'autre formant toit, une pluralité de montants parallèles, dont, d'une part, des montants de structure (12), qui s'étendent de l'un à l'autre desdits panneaux d'extrémité (11A, 11B) à leurs angles, et qui définissent conjointement au moins un compartiment (13), dit compartiment principal, en étant disposés chacun respectivement suivant les arêtes verticales de ce compartiment principal (13), et, d'autre part, des montants de support (14), qui interviennent dans ledit compartiment principal (13), entre les faces avant (15) et arrière (16) de celui-ci, et qui sont destinés à permettre la constitution d'un châssis (18) pour le support d'un quelconque équipement à loger dans ce compartiment principal (13), les panneaux d'extrémité (11A, 11B) présentant dans leurs angles des embouts (23) entre lesquels s'étendent les montants de structure (12), caractérisée en ce que, ceux, au moins, desdits montants de structure (12) qui interviennent sur la face avant (15) du compartiment principal (13) sont chacun individuellement rapportés de manière amovible sur les embouts (23) entre lesquels ils s'étendent, et les montants de support (14) sont déportés vers l'intérieur du compartiment principal (13) par rapport aux faces latérales (20) de celui-ci.

2. Ossature d'armoire suivant la revendication 1, caractérisée en ce que les montants de structure (12) sont des profilés à section transversale en U dont la concavité est orientée vers l'intérieur du compartiment principal (13), suivant la face latérale (20) correspondante de celui-ci.

3. Ossature d'armoire suivant la revendication 2, caractérisée en ce que, à chacune des extrémités d'un montant de structure (12), les ailes latérales (38) de ce montant de structure (12) présentent, en regard l'une de l'autre, au moins un perçage (40), pour l'intervention d'un tirant (41), qui, traversant de part en part l'embout (23) correspondant, assure le pincement du montant de structure (12) sur cet embout (23).

4. Ossature d'armoire suivant la revendication 3, caractérisée en ce que le tirant (41) est formé, d'une part, d'une douille entretoise (42), dont l'alésage interne (43) est taraudé, et qui présente extérieurement au moins un méplat (44) pour son blocage en rotation sur l'embout (23), et, d'autre part, d'une vis (45) en prise avec ladite douille entretoise (42).

5. Ossature d'armoire suivant la revendication 4, caractérisée en ce que pour le passage du tirant (41), l'embout (23) présente, en vis-à-vis, d'une part, un perçage (46), à la faveur duquel intervient la vis (45), et, d'autre part, un évidement (47), à la faveur duquel intervient la douille entretoise (42).

6. Ossature d'armoire suivant l'une quelconque des revendications 3 à 5, caractérisée en ce que, pour son assemblage à une autre ossature d'armoire, il est substitué, aux tirants (41) des montants de structure (12) par lesquels ces deux ossatures d'armoire (10) doivent être accolées, un tirant unique (41') de longueur suffisante pour traverser conjointement ces montants de structure (12).

7. Ossature d'armoire suivant l'une quelconque des revendications 3 à 6, caractérisée en ce que, à chacune des extrémités d'un montant de structure (12), l'une au moins des ailes latérales (38) de ce montant de structure (12) présente au moins un perçage (49) supplémentaire, pour l'intervention d'une vis (50) qui est directement en prise avec l'embout (23).

8. Ossature d'armoire suivant l'une quelconque des revendications 1 à 7, caractérisée en ce que les montants de structure (12) qui interviennent sur la face arrière (16) du compartiment principal (13) sont également chacun individuellement rapportés de manière amovible sur les embouts (23) entre lesquels ils s'étendent.

9. Ossature d'armoire suivant l'une quelconque des revendications 1 à 8, caractérisée en ce que les panneaux d'extrémité (11A, 11B) sont formés chacun d'un platelage (25), et de quatre noix d'angle (26), chacune de ces noix d'angle (26) comportant, en trièdre, d'une part, deux bras (27), par lesquels elle est solidarisée au platelage (25), et, d'autre part, l'embout (23) sur lequel est engagé le montant de structure (12) correspondant.

10. Ossature d'armoire suivant la revendication 9, caractérisée en ce que le platelage (25) des panneaux d'extrémité (11A, 11B) comporte un repli en U (28) le long de chacun de ses bords, et chacune des noix d'angle (26) est engagée par chacun de ses bras (27) dans le repli en U (28) correspondant de ce platelage (25).

11. Ossature d'armoire suivant l'une quelconque des revendications 9, 10, caractérisée en ce que, pour l'assemblage éventuel d'une ossature annexe (10'), chacune des noix d'angle (26) présente, extérieurement, à la jonction de ses bras (27), en dessous de son embout (23), un méplat à 45° (36), et il est prévu une patte de juxtaposition (80), qui, destinée à équiper à la place de la noix d'angle (26) le panneau d'extrémité (11'A) correspondant de cette ossature annexe (10'), comporte elle-même de manière complémentaire un méplat à 45° (81).

12. Ossature d'armoire suivant l'une quelconque des revendications 9 à 11, caractérisée en ce que le plan bissecteur des bras (27) d'une noix d'angle (26) passant par son embout (23) est un plan de symétrie pour l'ensemble.

13. Ossature d'armoire suivant l'une quelconque des revendications 1 à 12, caractérisée en ce qu'il est prévu, de manière intégrée, dans l'alignement du compartiment principal (13) à compter d'une des faces latérales (20) de celui-ci, un compartiment annexe (21).

14. Ossature d'armoire suivant l'une quelconque des revendications 1 à 13, caractérisée en ce que chacun des montants de support (14) s'étend entre deux consoles (54), dont chacune est solidaire d'un profilé (55) parallèle à la face latérale (20) correspondante du compartiment principal (13).

15. Ossature d'armoire suivant la revendication 14, caractérisée en ce que ledit profilé (55) présente à des niveaux différents deux épaulements (56, 57), l'un suivant lequel la console (54) lui est solidarisée, l'autre contre lequel cette console (54) est en simple appui.

16. Ossature d'armoire suivant les revendications 9 et 14, prises conjointement, caractérisée en ce que ledit profilé (55) s'étend de l'une à l'autre de deux noix d'angles (26), au contact du platelage (25) du panneau d'extrémité (11A, 11B) concerné, et il est solidarisé aux bras (27) correspondants de ces noix d'angle (26).

## Patentansprüche

1. Schrankskelett, das zwischen zwei Endplatten (11A, 11B), deren eine einen Boden und deren andere ein Dach bildet, eine Vielzahl von parallelen Ständern aufweist, und zwar einerseits Gerüstständer (12), die sich von einer der Endplatten (11A, 11B) zur anderen an deren Ecken erstrecken und zusammen mindestens ein Abteil (13), Hauptabteil genannt, abgrenzen, indem sie jeweils längs der vertikalen Kanten dieses Hauptabteils (13) angeordnet sind, und andererseits Tragständer (14), die in dem Hauptabteil (13) zwischen dessen Vorderseite (15) und dessen Rückseite (16) vorgesehen sind und die dazu bestimmt sind, die Bildung eines Rahmens (18) zum Tragen einer beliebigen, in diesem Hauptabteil (13) unterzubringenden Ausrüstung zu gestatten, wobei die Endplatten (11A, 11B) in ihren Ecken Ansätze (23) aufweisen, zwischen denen sich die Gerüstständer (12) erstrecken, dadurch gekennzeichnet, daß mindestens diejenigen der Gerüstständer (12), die an der Vorderseite (15) des Hauptabteils (13) vorgesehen sind, jeweils einzeln an den Ansätzen (23), zwischen denen sie sich erstrecken, lösbar angebracht sind, und die Tragständer (14) bezüglich der Seitenflächen (20) des Hauptabteils (13) auf dessen Inneres zu versetzt sind.

2. Schrankskelett nach Anspruch 1, dadurch gekennzeichnet, daß die Gerüstständer (12) Profilteile mit U-förmigem Querschnitt sind, dessen Konkavität in der entsprechenden Seitenfläche (20) des Hauptabteils (13) dessen Innerem zugewandt sind.

3. Schrankskelett nach Anspruch 2, dadurch gekennzeichnet, daß an jedem der Enden eines Gerüstständers (12) die Seitenwangen (38) dieses Gerüstständers (12) einander gegenüber mindestens eine Bohrung (40) zur Einführung eines Zugelements (41) aufweisen, das den entsprechenden Ansatz (23) ganz durchquert und die Verklemmung des Gerüstständers (12) auf diesem Ansatz (23) gewährleistet.

4. Schrankskelett nach Anspruch 3, dadurch gekennzeichnet, daß das Zugelement (41) einerseits von einer Distanzbuchse (42) gebildet ist, deren Innenbohrung (43) mit Innengewinde versehen ist und die außen mindestens eine Abflachung (44) für ihre Blockierung an dem Ansatz (23) bezüglich Drehung aufweist, und andererseits von einer Schraube (45), die in diese Distanzbuchse (42) eingeschraubt ist.

5. Schrankskelett nach Anspruch 4, dadurch gekennzeichnet, daß der Ansatz (23) für den Durchgang des Zugelements (41) einander gegenüberstehend einerseits eine Bohrung (46), welche die Schraube (45) durchquert, und andererseits eine Aussparung (47) aufweist, durch welche die Distanzbuchse (42) hindurchtritt.

6. Schrankskelett nach einem der Ansprüche 3 bis 5, dadurch gekennzeichnet, daß für seinen Zusammenbau mit einem anderen Schrankskelett anstelle der Zugelemente (41) der Gerüstständer (12), mit denen diese Schrankskelette (10) aneinandergesetzt werden sollen, ein einziges Zugelement (41') mit ausreichender Länge vorgesehen ist, um diese Gerüstständer (12) gemeinsam zu durchqueren.

7. Schrankskelett nach einem der Ansprüche 3 bis 6, dadurch gekennzeichnet, daß mindestens eine der Seitenwangen (38) eines Gerüstständers (12) an jedem der Enden dieses Gerüstständers (12) mindestens eine zusätzliche Bohrung (49) zur Einführung einer Schraube (50) aufweist, die direkt in den Ansatz (23) eingeschraubt ist.

8. Schrankskelett nach einem der Ansprüche 1 bis 7, dadurch gekennzeichnet, daß die Gerüstständer (12) die auf der Rückseite (16) des Hauptabteils (13) angeordnet sind, ebenfalls jeweils einzeln an den Ansätzen (23), zwischen denen sie sich erstrecken, lösbar angebracht sind.

9. Schrankskelett nach einem der Ansprüche 1 bis 8, dadurch gekennzeichnet, daß die Endplatten (11A, 11B) jeweils von einem Belag (25) und von vier Eckstücken (26) gebildet sind, deren jedes in einem Trieder einerseits zwei Arme (27), mit denen es mit dem Belag (25) fest verbunden sind, und andererseits den Ansatz (23) aufweist, auf den der entsprechende Gerüstständer (12) aufgesteckt ist.

10. Schrankskelett nach Anspruch 9, dadurch gekennzeichnet, daß der Belag (25) der Endplatten (11A, 11B) längs jedes seiner Ränder eine U-förmige Umbiegung (28) aufweist und jedes der Eckstücke (26) mit jedem seiner Arme (27) in die entsprechende U-förmige Umbiegung (28) dieses Belags (25) eingesetzt ist.

11. Schrankskelett nach einem der Ansprüche 9, 10, dadurch gekennzeichnet, daß jedes der Eckstücke (26), für die eventuelle Montage eines Anbauskeletts (10'), außen an der Verbindung seiner Arme (27) unter seinem Ansatz (23) eine 45°-Abflachung (36) aufweist und ein Montageelement (80) vorgesehen ist, das dazu bestimmt ist, an der Stelle des Eckstücks (26) die entsprechende Endplatte (11`A) dieses Anbauskeletts (10') zu bestücken, und seinerseits ergänzend eine 45°-Abflachung (81) aufweist.

12. Schrankskelett nach einem der Ansprüche 9 bis 11, dadurch gekennzeichnet, daß die Winkelhalbierungsebene der Arme (27) eines Eckstücks (26), die durch seinen Ansatz (23) verläuft, eine Symmetrieebene für die Einheit ist.

13. Schrankskelett nach einem der Ansprüche 1 bis 12, dadurch gekennzeichnet, daß in der Flucht des Hauptabteils (13) von einer dessen Seitenflächen (20) aus integriert ein Zusatzabteil (21) vorgesehen ist.

14. Schrankskelett nach einem der Ansprüche 1 bis 13, dadurch gekennzeichnet, daß jeder der Tragständer (14) sich zwischen zwei Konsolen (54) erstreckt, deren jede mit einem Profilteil (55) fest verbunden ist, das zu der entsprechenden Seitenfläche (20) des Hauptabteils (13) parallel ist.

15. Schrankskelett nach Anspruch 14, dadurch gekennzeichnet, daß dieses Profilteil (55) in verschiedenen Höhen zwei Schultern (56, 57) aufweist, an einer deren die Konsole (54) befestigt ist und auf deren anderen diese Konsole (54) einfach aufliegt.

16. Schrankskelett nach den Ansprüchen 9 und 14 zusammen, dadurch gekennzeichnet, daß das Profilteil (55) sich von einem von zwei Eckstücken (26) zum anderen in Kontakt mit dem Belag (25) der betreffenden Endplatte (11A, 11B) erstreckt und an den entsprechenden Armen (27) dieser Eckstücke (26) befestigt ist.

## Claims

1. A cabinet framework of the kind comprising, between two end panels (11A, 11B), one forming a floor and the other forming a top, a plurality of parallel uprights comprising on the one hand structural uprights (12) which extend from one of said end panels (11A, 11B) to the other at the corners thereof and which jointly define at least one compartment (13), referred to as the main compartment, each being disposed along respective ones of the vertical edges of said main compartment (13), and, on the other hand, support uprights (14) which are operatively disposed in said main compartment (13) between the front (15) and rear (16) faces thereof and which are intended to permit the constitution of a chassis (18) for supporting any item of equipment to be housed in said main compartment (13), the end panels (11A, 11B) having at the corners thereof connecting portions (23) between which the structural uprights (12) extend, characterised in that those at least of said structural uprights (12) which are operatively disposed on the front face (15) of the main compartment (13) are each individually fitted removably to the connecting portions (23) between which they extend, and the support uprights (14) are offset towards the interior of the main compartment (13) with respect to the side faces (20) thereof.

2. A cabinet framework according to claim 1 characterised in that the structural uprights (12) are shaped members of U-shaped cross-section whose concavity is oriented towards the interior of the main compartment (13) along the corresponding side face (20) thereof.

3. A cabinet framework according to claim 2 characterised in that at each of the ends of a structural upright (12) the side limbs (38) of said structural upright (12) have in mutually facing relationship at least one opening (40) for the operative arrangement of a tie member (41) which, passing through the corresponding connecting portion (23), provides for gripping the structural upright (12) on to said connecting portion (23).

4. A cabinet framework according to claim 3 characterised in that the tie member (41) is formed on the one hand by a bracing sleeve (42) whose internal bore (43) is screwthreaded and which externally has at least one flat (44) for locking it non-rotatably on the connecting portion (23), and, on the other hand, a screw (45) in engagement with said bracing sleeve (42).

5. A cabinet framework according to claim 4 characterised in that, for the tie member (41) to pass therethrough, the connecting portion (23) has in mutually facing relationship on the one hand an opening (46) through which the screw (45) passes and on the other hand a recess (47) through which the bracing sleeve (42) passes.

6. A cabinet framework according to any one of claims 3 to 5 characterised in that, for assembly thereof to another cabinet framework, the tie members (41) of the structural uprights (12) by way of which said two cabinet frameworks (10) are to be disposed in coupled relationship are replaced by a single tie member (41') of sufficient length to pass jointly through said structural uprights (12).

7. A cabinet framework according to any one of claims 3 to 6 characterised in that at each of the ends of a structural upright (12) one at least of the side limbs (38) of said structural upright (12) has at least one additional opening (49) for a screw (50) which is directly in engagement with the connecting portion (23).

8. A cabinet framework according to any one of claims 1 to 7 characterised in that the structural uprights (12) which are operatively disposed at the rear face (16) of the main compartment (13) are also each individually fitted removably to the connecting portions (23) between which they extend.

9. A cabinet framework according to any one of claims 1 to 8 characterised in that the end panels (11A, 11B) are each formed by a plate portion (25) and four corner mounting members (26), each of said corner mounting members (26) comprising in trihedral relationship on the one hand two arms (27) by way of which it is fixed with respect to the plate portion (25) and on the other hand the connecting portion (23) on which the corresponding structural upright (12) is engaged.

10. A cabinet framework according to claim 9 characterised in that the plate portion (25) of the end panels (11A, 11B) comprises a U-shaped bend portion (28) along each of its edges and each of the corner mounting members (26) is engaged by each of its arms (27) in the corresponding U-shaped bend portion (28) of said plate portion (25).

11. A cabinet framework according to either one of claims 9 and 10 characterised in that, for possible assembly of an adjoining framework (10'), each of the corner mounting members (26) is externally provided at the junction of its arms (27) below its connecting portion (23) with a 45° flat (36) and there is provided a juxtaposition lug member (80) which, being intended to be fitted in place of the corner mounting member (26) to the corresponding end panel (11'A) of said adjoining framework (10'), itself comprises in complementary manner a 45° flat (81).

12. A cabinet framework according to any one of claims 9 to 11 characterised in that the plane bisecting the arms (27) of a corner mounting member (26) that passes through its connecting portion (23) is a plane of symmetry for the assembly.

13. A cabinet framework according to any one of claims 1 to 12 characterised in that there is provided an adjoining compartment (21) in integrated fashion in alignment with the main compartment (13) from one of the side faces (20) thereof.

14. A cabinet framework according to any one of claims 1 to 13 characterised in that each of the support uprights (14) extends between two brackets (54), each of which is fixed with respect to a shaped member (55) parallel to the corresponding side face (20) of the main compartment (13).

15. A cabinet framework according to claim 14 characterised in that at different levels said shaped member (55) has two shoulders (56, 57), one along which the bracket (54) is fixed with respect thereto and the other against which said bracket (54) simply bears.

16. A cabinet framework according to claims 9 and 14 in combination characterised in that said shaped member (55) extends from one of two corner mounting members (26) to the other in contact with the plate portion (25) of the end panel (11A, 11B) in question and it is fixed with respect to the corresponding arms (27) of said corner mounting members (26).
